# EUROPEAN PATENT APPLICATION

(11) **EP 4 722 856 A1**
(43) Date of publication of application: **08.04.2026**
(21) Application number: 25204939.0
(22) Date of filing: 26.09.2025
(51) Int. Cl.: G06F 1/20, G06F 1/3206, G06F 1/3228, G06F 1/324, G06F 1/329, G06F 1/3296, H05K 7/20, G06N 20/00

(54) **SYSTEM AND METHOD FOR CO-OPTIMIZING POWER AND TEMPERATURE FLUCTUATION DURING SYSTEM DEEP IDLE**

(30) Priority: 01.10.2024 US 202418903755
(71) Applicant: Google LLC, Mountain View, CA 94043 (US)
(72) Inventor: GAN, Houle, Mountain View, 94043 (US); RANGANATHAN, Parthasarathy, Mountain View, 94043 (US); PADMANABHAN, Rammohan, Mountain View, 94043 (US)
(74) Representative: Betten & Resch

(57) **Abstract**

Generally disclosed herein is an approach to mitigating hardware degradation of server machines caused by frequent chip temperature fluctuations based on controlling the power consumption level, changes in xPU temperature of server machines, and the job start latency for the server machines altogether. According to some examples, a power and temperature optimization system may monitor xPU temperature fluctuations caused by inter-job fluctuations related to the xPU's deep idle state. The xPU's deep idle state may refer to a state where the xPU turns off or reduces the voltage of the xPU components to save power when a job or a unit of work assigned to the xPU stops. The xPU's deep idle state may continue until the next job or unit of work starts.

## Description

Data centers house various electronic components. The increased use of artificial intelligence (AI) or machine learning (ML) can cause frequent workload fluctuations, which in turn may cause frequent chip temperature fluctuations. Such frequent temperature fluctuations may result in thermal interface material (TIM) degradation in electronic components such as various ML accelerator machines and high tray annualized swap rate (ASR). The TIM degradation in the electronic components can ultimately cause operational failures or reduced reliability of the performance of the electronic components.

### SUMMARY

Generally disclosed herein is a mechanism to mitigate hardware degradation of server machines caused by frequent chip temperature fluctuations based on dynamically and concurrently controlling power consumption level, changes in xPU temperature of server machines, and job start latency for the server machines.

An aspect of the disclosure provides a system for optimizing power and thermal control of a server system, the system comprising memory; one or more processors in communication with the one or more memories, the one or more processors configured to: receive state data of the server system; determine that a current job is near completion based on the received state data; reduce an amount of power supplied to the server system over a predefined time period; reduce a rate of cooling by closing one or more cooling valves over the predefined time period; change a latency time of the current job or a next scheduled job; and maintain a temperature of the server system at predefined level based on the reduced amount of the power, the changed latency time, and the reduced rate of cooling.

In some examples, the state data includes job schedules, temperatures of one or more components of the server system, and states of the one or more cooling valves for a server cooling system.

In some examples, the one or more processors are configured to reduce the amount of power supplied to the server system using a dynamic voltage and frequency scaling (DVFS) technique.

In some examples, the one or more processors are configured to reduce fan speeds of one or more fans equipped in the server system to change the temperature of the server system.

In some examples, the one or more processors are configured to represent the reduced amount of the power, the changed latency time, and the reduced rate of cooling using a metric function.

In some examples, the one or more processors are configured to optimize the metric function using a machine learning model.

In some examples, the system comprises one or more actuators configured to control the one or more cooling valves and change the latency time.

In some examples, the one or more processors are configured to change the latency time of the current job or the next scheduled job using a scheduler, wherein the scheduler is configured to delay a time of loading the current job or the next scheduled job.

Another aspect of the disclosure provides method for optimizing power and thermal control of a server system, the method comprising: receiving, by one or more processors, state data of the server system; determining, by the one or more processors, that a current job is near completion based on the received state data; reducing, by the one or more processors, an amount of power supplied to the server system over a predefined time period; reducing, by the one or more processors, a rate of cooling by closing one or more cooling valves over the predefined time period; changing, by the one or more processors, a latency time of the current job or a next scheduled job; and maintaining, by the one or more processors, a temperature of the server system at predefined level based on the reduced amount of the power, the changed latency time, and the reduced rate of cooling.

In some examples, the state data includes job schedules, temperatures of one or more components of the server system, and states of the one or more cooling valves for a server cooling system.

In some examples, the method further comprises reducing, by the one or more processors, the amount of power supplied to the server system using a dynamic voltage and frequency scaling (DVFS) technique.

In some examples, the method further comprises reducing, by the one or more processors, fan speeds of one or more fans equipped in the server system to change the temperature of the server system.

In some examples, the reduced amount of the power, the changed latency time, and the reduced rate of cooling are represented using a metric function.

In some examples, the method further comprises optimizing, by the one or more processors, the metric function using a machine learning model.

In some examples, the method further comprises controlling, by one or more actuators, the one or more cooling valves and changing the latency time.

In some examples, the method further comprises changing the latency time of the current job or the next scheduled job using a scheduler, wherein the scheduler is configured to delay a time of loading the current job or the next scheduled job.

Yet another aspect of the disclosure provides a non-transitory machine-readable medium comprising machine-readable instructions encoded thereon for performing a method of optimizing power and thermal control of a server system, the method comprising: receiving state data of the server system; determining that a current job is near completion based on the received state data; reducing an amount of power supplied to the server system over a predefined time period; reducing a rate of cooling by closing one or more cooling valves over the predefined time period; changing a latency time of the current job or a next scheduled job; and maintaining a temperature of the server system at predefined level based on the reduced amount of the power, the changed latency time, and the reduced rate of cooling.

In some examples, the state data includes job schedules, temperatures of one or more components of the server system, and states of the one or more cooling valves for a server cooling system.

In some examples, the method further comprises reducing the amount of power supplied to the server system using a dynamic voltage and frequency scaling (DVFS) technique.

In some examples, the method further comprises reducing fan speeds of one or more fans equipped in the server system to change the temperature of the server system.

### BRIEF DESCRIPTION OF THE DRAWINGS

FIG. 1 is a schematic representation of a power and temperature optimization system for a data center in accordance with aspects of the disclosure.
FIG. 2 is an example power and temperature optimization controller in accordance with aspects of the disclosure.
FIG. 3 is an example power and temperature optimization system in accordance with aspects of the disclosure.
FIG. 4 provides vertically aligned graphs representing power consumption level, valve open percentage, and temperature changes in accordance with aspects of the disclosure.
FIG. 5 is an example flow diagram of the power and temperature optimization system in accordance with aspects of the disclosure.

### DETAILED DESCRIPTION

The present disclosure relates to mitigating hardware degradation of server and accelerator machines caused by frequent chip temperature fluctuations based on controlling the power consumption level, changes in xPU temperature of server machines, and the job start latency for the server machines altogether. According to some examples, a power and temperature optimization system may monitor xPU temperature fluctuations caused by inter-job fluctuations related to the xPU's deep idle state. The xPU's deep idle state may refer to a state where the xPU turns off or reduces the voltage of the xPU components to save power when a job or a unit of work assigned to the xPU stops. The xPU's deep idle state may continue until the next job or unit of work starts.

Frequent inter-job fluctuations may be caused by large-scale Artificial Intelligence (AI) training workloads and lead to frequent xPU temperature fluctuations. xPU for the purpose of the present disclosure may include any type of computing ASICs, such as central processing unit (CPU), graphics processing unit (GPU), tensor processing unit (TPU), etc. The frequent xPU temperature fluctuations may result in thermal interface materials (TIM) degradation of the hardware components of machine servers such as machine learning accelerator machines and xPU trays. The thermal interface material may include materials used to dissipate and improve the transfer of heat out of electronic devices. They may be placed between the heatgenerating chip and/or component.

The inter-job xPU temperature fluctuations may be mitigated by purposefully increasing power demand, referred to as "padding power", between one job and the next job, such that the xPU's power consumption nominally increases, and the xPU temperature remains relatively constant. Padding power can be performed by launching an unauthentic job, un-gating the xPU clock tree, or inserting instructions into the xPU's pipeline. However, this approach may consume a large amount of extra power to maintain the xPU at a steady temperature.

Another approach for mitigating temperature fluctuations may involve controlling cooling devices, such as fans or fluid-controlling valves. When the power demand drops when the workloads decrease, the cooling component may be throttled to prevent the xPU temperature from decreasing.

The power and temperature optimization system described herein is configured to detect a job-ending signal and decrease power gradually through staggered dynamic voltage and frequency scaling (DVFS), thereby allowing time for collaborated fluid valve control or fan speed control to achieve substantially flat temperature.

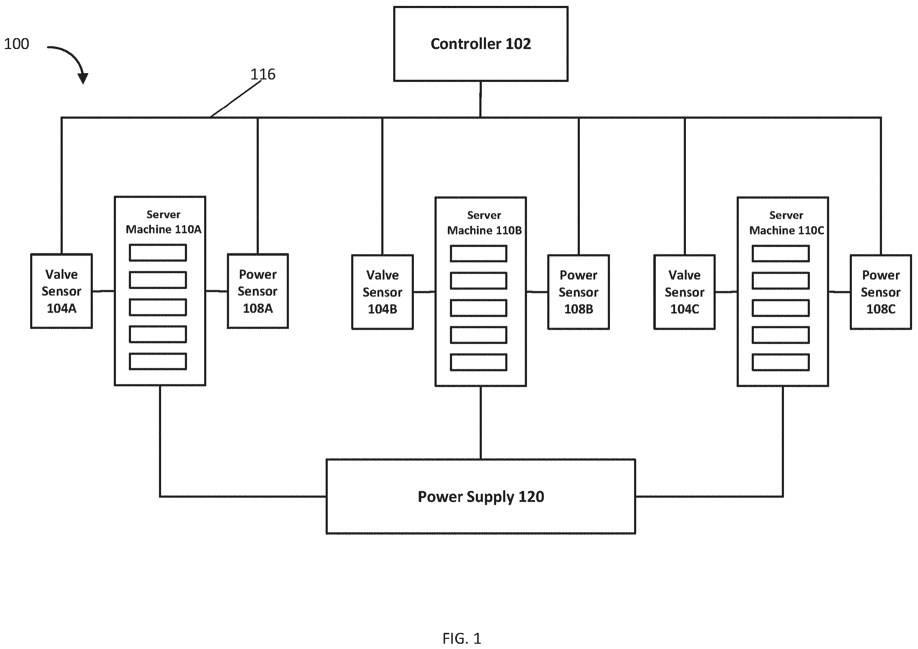

FIG. 1 is a schematic representation of a power and temperature optimization system 100 ("system") for a data center. The system includes controller 102, power supply 120, and server machines 110A-C. Each server machine is connected to valve sensors 104A-C and power sensors 108A-C, respectively.

Each power sensor may be configured to measure the changes in the amount of workload for each server machine. Each power sensor may also be configured to monitor the amount of power being consumed by each server machine and monitor the power received from power supply 120. Each power sensor may transmit the measured data to controller 102 at a preconfigured interval. Each power sensor may send the power consumption measurement in watts to controller 102 via bus 116. Bus 116 may include a physical layer implementing a communication protocol between power consumption sensors attached to each server machine or each computing device and controller 102.

Valve sensors 104A-C may be connected to the server machines 110A-C. Each valve sensor 104A-C may be part of a cooling system that operates to provide cooling for a respective server machine 110A-C. Valve sensors 104A-C may communicate with controller 102 via bus 116. Valve sensors 104A-C may be configured to receive commands from controller 102 and to change an opening percentage of the valve accordingly. Changing the valve opening percentage results in increased or decreased cooling material flow, such as air or liquid. If the valve opening percentage increases, a larger amount of air/liquid flows through the cooling system coupled to each server machine, thereby reducing the temperature around each server machine.

Each server machine may also include a temperature sensor (not shown) that may be configured to send the chip power dissipation data and the current temperature measurements to controller 102 via bus 116. Controller 102 may use the measured temperatures of each server machine and determine whether to change the opening percentage of the valves.

Server machines 110A-C include one or more computing devices used for various purposes, such as internet hosting, cloud computing, etc. The computing devices may include processors that include one or more individual circuits, transistors, and/or other components. Each operation performed at a circuit may require at least a small amount of power, and thus, each operation generates a certain amount of heat as a byproduct. As the amount of power required for each server machine fluctuates, the amount of heat dissipated by the server machines may fluctuate, thereby causing temperature fluctuations of the TIMs included in the computing devices.

Controller 102 may be configured to control the amount of power supplied to each machine from power supply 120, the valve open percentage, and job start latency for each server machine. For example, controller 102 may determine when the current job will be completed, and the temperature of each server machine will decrease as the workloads and the power demand decrease. Controller 102 may command power supply 120 to gradually reduce the power supply even after the current job is completed such that the temperature of each server machine may decrease gradually as well. Controller 102 may also decrease the valve opening percentage via valve sensors 104A-C. As the valve open percentage decreases, less air or liquid can flow through cooling devices and can slow the rate of temperature decrease for each server machine when the supplied amount of power decreases. Controller 103 may also control the start time of the next workload or job such that each server machine can have sufficient time to smooth the temperature fluctuations and transition into the next job without experiencing significant temperature fluctuations.

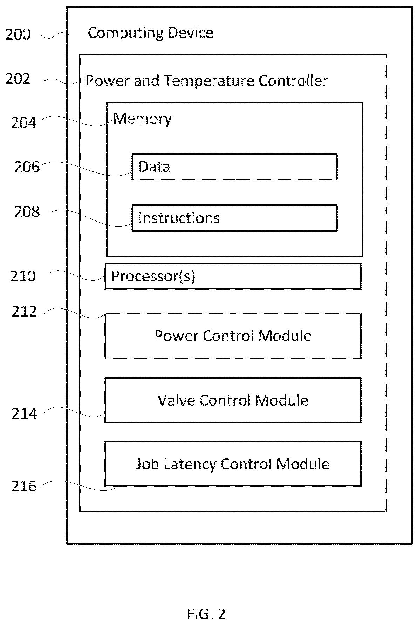

FIG. 2 is a block diagram illustrating an example computing device 200 according to aspects of this disclosure. The computing device can take on a variety of configurations, such as, for example, a controller or microcontroller, or a processor, such as a CPU, a GPU, or an ASIC, including a tensor processing unit (TPU). The computing device may further include a power and temperature controller 202. The power and temperature controller 202 may be configured to control the amount of power supplied to each server machine from the power supply, the valve open percentage of the cooling devices, and job start latency for each server machine.

Power and temperature controller 202 may include a processor 210, memory 204 including data 206 and instructions 208, power control module 212, valve control module 214 and job latency control module 214 as well as other components typically present in server computing devices. In other examples, such operations may be performed by one or more of the computing devices in a data center or elsewhere.

The memory 204 can store information accessible by the processor 210, including instructions 208 that can be executed by the processor 210. Memory can also include data 206 that can be retrieved, manipulated, or stored by the processor 210. Memory 204 may be a type of non-transitory computer-readable medium capable of storing information accessible by the processor 210, such as a hard drive, solid-state drive, tape drive, optical storage, memory card, ROM, RAM, DVD, CD-ROM, write-capable, and read-only memories. The processor 210 can be a well-known processor or other lesser-known types of processors. Alternatively, the processor 210 can be a dedicated controller such as an ASIC.

The instructions 208 can be a set of instructions executed directly, such as machine code, or indirectly, such as scripts, by the processor 210. In this regard, the terms "instructions"," "steps," and "programs" can be used interchangeably herein. The instructions 208 can be stored in object code format for direct processing by the processor 210, or other types of computer language including scripts or collections of independent source code modules that are interpreted on demand or compiled in advance. For example, instructions 208 may include instructions for valve sensors 104A-C and power supply 120 depicted in FIG.1 to change the valve opening percentage of the cooling devices or adjust the amount of the power supply provided by power supply 120 in FIG.1.

The data 206 can be retrieved, stored, or modified by the processor 210 in accordance with the instructions 208. For instance, although the system and method are not limited by a particular data structure, the data 206 can be stored in computer registers, in a relational database as a table having a plurality of different fields and records, or in XML documents. The data 206 can also be formatted in a computer-readable format such as, but not limited to, binary values, ASCII, or Unicode. Moreover, data 206 can include information sufficient to identify relevant information, such as numbers, descriptive text, proprietary codes, pointers, references to data stored in other memories including other network locations, or information that is used by a function to calculate relevant data. Data 206 can include historical data pertaining to the correlation between the amount of power supply, the opening percentage of the valves, and the changes in the temperatures of the server machines.

Power control module 212 may command power supply 120 to decrease the amount of power to be supplied when power and temperature controller 202 detect a job-ending signal or during a deep idle state. The power supplied from power supply 120 may be configured to decrease gradually through dynamic voltage and frequency scaling (DVFS) techniques. The gradual power decrease may allow time for valve control module 214 to adjust the valve opening percentages via valve sensors 104A-C.

Valve control module 214 may command actuators (not shown) connected to either valve sensors 104A-C or server machines s 110A-C. Either air or liquid flow rate may be adjusted to control the temperature fluctuations caused by the changes in the amount of power supplied from power supply 120. When the valve opening percentages increase, the amount of air or liquid flow increases, and the cooling effect can be enhanced. If the valve opening percentage decreases, the amount of air or liquid flow decreases, and the cooling effect can be reduced.

Job latency control module 216 may delay the start time of the next job assigned to each server machine. For example, power and temperature controller 202 may determine when the current job will be completed and use power control module 212 and valve control module 214 to maintain the temperature of the server machine at a substantially flat level. To allow sufficient time for the cooling device and the changes in the amount of power supply to take effect, job latency control module 216 may delay the assignment of the next job by x seconds such that any changes in the valve opening percentage and changes in the amount of power supply may take effect before the next job begins.

FIG. 2 functionally illustrates processor 210 and memory 204 as being within the same block, but processor 210 and memory 203 may instead include multiple processors and memories that may or may not be stored within the same physical housing. For example, some of the instructions 208 and data 206 may be stored on a removable CD-ROM and others may be within a read-only computer chip. Some or all of the instructions and data can be stored in a location physically remote from, yet still accessible by, the processor 210. Similarly, the processor 210 can include a collection of processors, which may or may not operate in parallel.

It is to be appreciated that in this example, power control module 212, valve control module 214, and job latency control module 216 are shown as part of power and temperature controller 202. In other examples, power control module 212, valve control module 214, and job latency control module 216 may be implemented in one or more other systems or computing devices.

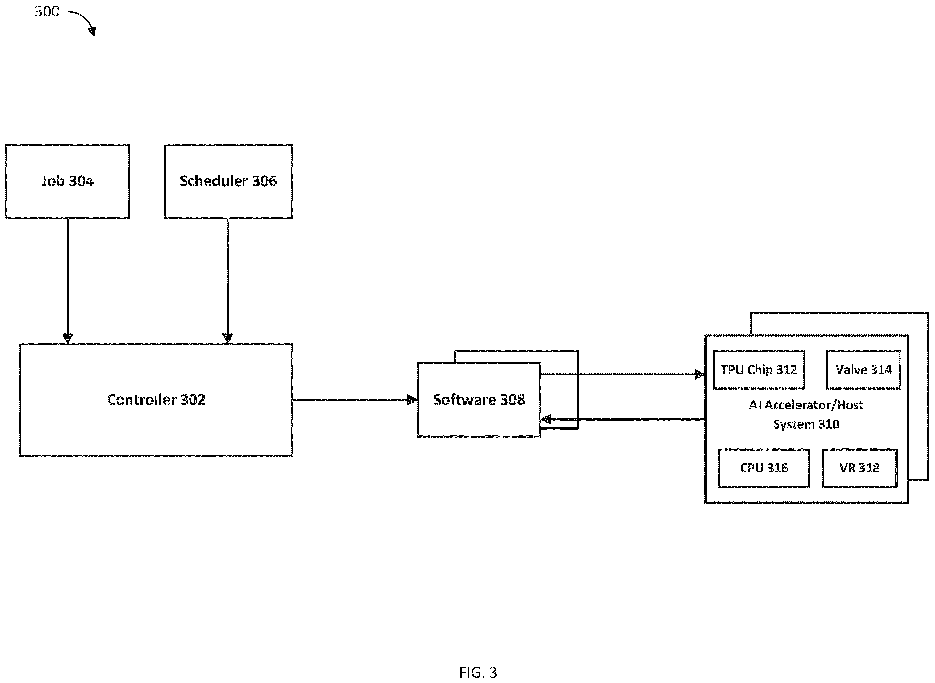

FIG. 3 illustrates an example power and temperature optimization system. The system may include controller 302, software 308, and host system 310. Controller 302 may be equivalent to power and temperature controller 202 depicted in FIG.2. Controller 302 may be configured to decrease power gradually through staggered dynamic voltage and frequency scaling (DVFS), thereby allowing time for collaborated fluid valve control or fan speed control to achieve substantially flat temperature. Controller 302 may be configured to receive job 304. Controller 302 may be configured to receive both the job-ending signal and job-starting signal from scheduler 306. Controller 302 may transmit the ending signal and starting signal to specialized software 308 configured to receive various data from the AI accelerator machine (e.g. TPU) and/or host system 310. The specialized software 308 may also be configured to control various functions of the AI accelerator and the host system 310 using one or more actuators. AI accelerator machine and/or host system 310 may include TPU chip 312, valve 314, CPU 316, and voltage regulator (VR) 318.

Specialized software 308 may be configured to receive data such as the AI accelerator's chip power consumption amount and the AI accelerator's chip temperature from TPU chip 312 and CPU 316, the host system's power consumption amount from VR 318, and data related to the valve opening percentage of the cooling devices. Specialized software 308 may further be configured to receive control instructions from controller 302 and transmit the control instructions to the AI accelerator machine/host system 310 using one or more actuators. The actuators may be configured to change the power consumption amount using VR 318, clock frequency of change in power consumption by CPU 316 or TPU chip 312, TPU chip 312's clock gating and/or un-gating, cooling components such as fluid-valve or fans, the host CPU 316's state (i.e. performance state (p-state), idle state (c-state), sleeping state (s-state)), and added latency time to the current or the next job. The actuators may also be configured to change the valve opening percentage using valve 314.

According to some examples, controller 302 may be configured to generate an optimized metric function f (*P_{idle}*, *dT_{idle}*, *tₗₐₜ*), while maintaining each parameter, *P_{idle}, dT_{idle}* and *tₗₐₜ* within its limits. *P_{idle}* may refer to the power consumption amount of the AI accelerator machine/host system 310 in a deep idle state. *dT_{idle}* may refer to the CPU 316 and/or TPU chip 312's temperature change from a deep idle state to a state where power demand is above a predetermined threshold. *tₗₐₜ* may refer to an added latency time to the start of the next job. Controller 302 may be configured to adopt various values for each parameter within their limits for the above function.

For example, controller 302 may be configured to maintain that: *P_{idle}* < 1kW, *dT_{idle}*,<15C, *tₗₐₜ* < 1sec, and the metric function f (*P_{idle}*, *dT_{idle}*, *tₗₐₜ*) may be defined to be the total cost representing the idle power consumption operation expense plus the cost of TIM degradation plus the cost associated with performance impact from the added latency to the next job. The respective costs may be quantified, for example, in monetary values or any other units of measurement. Controller 302 may be configured to minimize the magnitude of the output of the metric function while maintaining each parameter within the respective limit as shown above.

In some examples, controller 302 may be configured to operate in one or more stages in the AI accelerator machine/host system 310's deep idle state: (1) deep idle awareness stage: scheduler 306 may be configured to notify controller 302 that the current job will end in x seconds and release the AI accelerator machine/host system 310. Scheduler 306 may transmit RPC calls or any form of cross-software communication to notify controller 302 of the job ending signal; (2) ramp-down transition stage: controller 302 may be configured to use the specialized software 308 to notify each of the machines that were assigned to the current job to start transitioning into the deep idle state. Specialized software 308 may be configured to command DVFS to start to gradually reduce power level, cooling device's valve or fans are configured to gradually reduce air or liquid flow or fan speed, and prompt CPU 316 and/or TPU chip 312 to enter lower c-state or p-state in which the power consumption amount is gradually reduced. Various actuators may be adjusted in a coordinated fashion to achieve optimal output of the metric function described above; (3) steady-state deep idle stage: controller 302 may be configured to monitor whether the actuators setting reach steady-state levels and implement various control loops to maintain the metric function remains constant in an optimal range. In some examples, the metric functions may be optimized using a machine learning model; (4) incoming job awareness stage: scheduler 306 may be configured to notify controller 302 that the next job starts in x seconds; (5) ramp-up transition stage: controller 302 may notify via specialized software 308 all machines that are assigned to the next job to transition out of the deep idle state. DVFS may be configured to gradually increase power level, fluid valves, and cooling devices may be configured to gradually increase the air or liquid flow or fan speed, and CPU 316 may be configured to enter a higher c-state or p-state in which the power consumption amount is significantly increased.

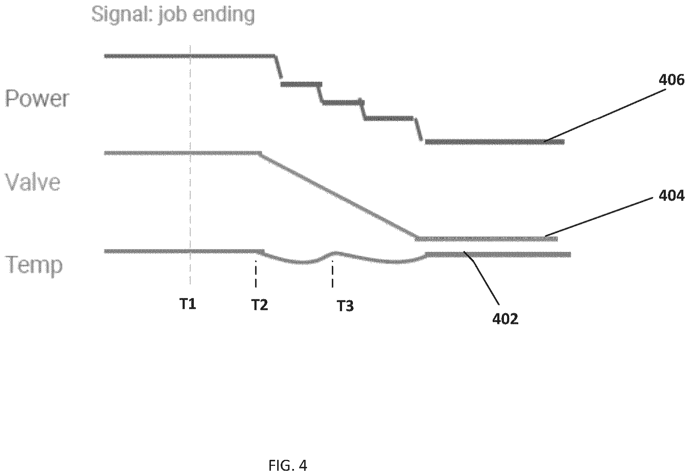

FIG. 4 illustrates vertically aligned graphs representing a correlation between power consumption level, valve open percentage, and temperature changes. Graph line 406 represents the changes in the power amount over time. Graph line 404 represents the changes in the valve opening percentages of the cooling devices over time. Graph line 402 represents the changes in temperatures of a server machine over time. At T1, scheduler 306 may notify controller 302 that the current job is ending soon. At T2, once controller 302 receives the job ending signal, controller 302 may use specialized software 308 to adjust the power amount and valve opening percentage to mitigate the temperature fluctuations. During the period between T2 and T3, the temperature initially starts to decrease in response to the power amount decreasing, but as the valve opening percentage also begins to decrease and the cooling effect of the cooling devices gradually decreases, the temperature increases and reaches back to the original temperature at T3. At T3, even though the power amount continues to decrease, the temperature does not decrease any further since the valve opening percentage also continues to decrease and counteracts the effect of the decrease in the power amount.

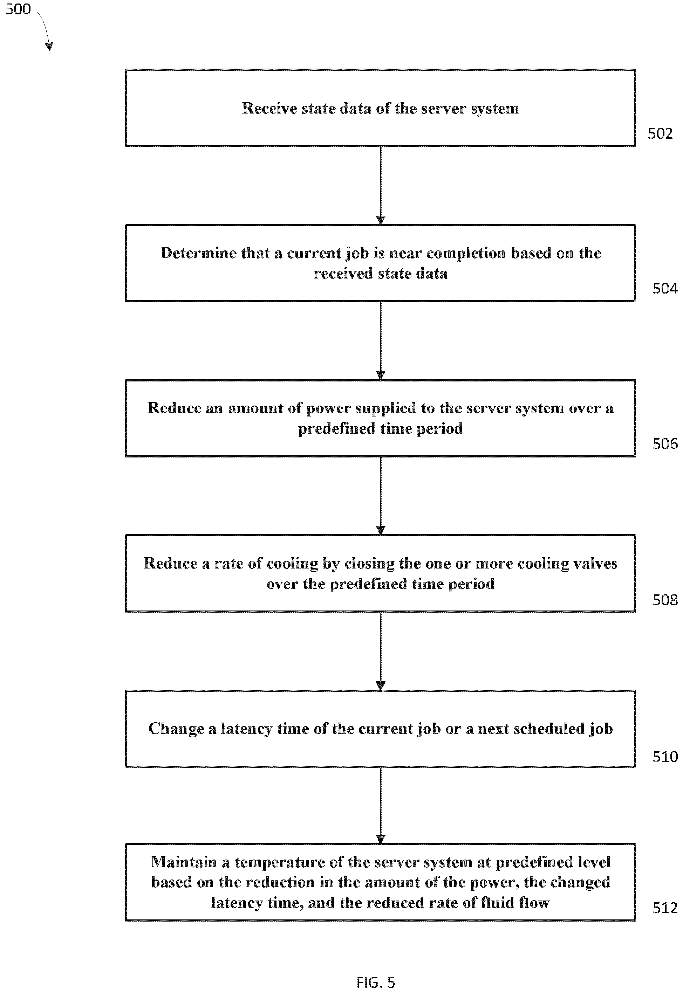

FIG. 5 illustrates an example flow diagram of the power and temperature optimization system. According to block 502, the system may be configured to receive state data of the server system. The state data may include each server machine's chip temperature, power consumption amount, job schedules, and the valve opening percentage of the cooling devices connected to each server machine.

According to block 504, the system may be configured to determine that a current job is near completion based on the received state data. According to some examples, the system may receive a job-starting signal and a job-ending signal from a scheduler software. Based on the job-ending signal received from the scheduler software, the system may prepare to notify server machines that were assigned to the current job to start transitioning into a deep idle state.

According to block 506, the system may be configured to reduce an amount of power supplied to the server system over a predefined time period. According to some examples, the system may be configured to command one or more actuators to control the amount of power supplied from the power supply connected to the server machines. For example, if the server machines s are in deep idle states and no jobs are currently assigned to the server machines, the system may determine that the server machines need less amount of power from the power supply.

According to block 508, the system may be configured to reduce a rate of cooling by closing the one or more cooling valves over the predefined time period. According to some examples, when the server machines require less power from the power supply, the temperature of the server machines may decrease as less amount of heat is dissipated from the chips in the server machines. As frequent temperature fluctuations may degrade the electrical components of the server machines, the system may send control instructions to the cooling valves of the cooling devices to reduce the air and/or liquid flow of the cooling devices to reduce the cooling effect and counteract the temperature fluctuations.

According to block 510, the system may be configured to change the latency time of the current job or the next scheduled job. According to some examples, the system may delay the start time of the next job assigned to each server machine. For example, the system may delay the assignment of the next job by x seconds until the effect of changing the valve opening percentages becomes effective.

According to block 512, the system may be configured to maintain the temperature of the server system at a predefined level based on the reduction in the amount of power, the changed latency time, and the reduced rate of air/liquid flow. According to some examples, the system may adjust the various actuators in a coordinated fashion to achieve an optimal level of the amount of power, the latency time, and the rate of the air/liquid flow to maintain the temperature at the predefined level using a metric function.

The power and temperature optimization system described herein is beneficial at least in that it provides for optimization of the amount of power, job latency time, and valve opening percentages simultaneously to maintain the server machines at a steady temperature. The system may mitigate the effect of frequent inter-job workload fluctuations caused by large-scale AI training workloads leading to frequent xPU temperature fluctuations, thereby preventing potential thermal interface materials (TIM) degradation of the xPU components or other hardware components of the server machines.

In this specification, the phrase "configured to" is used in different contexts related to computer systems, hardware, or part of a computer program, engine, or module. When a system is said to be configured to perform one or more operations, this means that the system has appropriate software, firmware, and/or hardware installed on the system that, when in operation, causes the system to perform the one or more operations. When some hardware is said to be configured to perform one or more operations, this means that the hardware includes one or more circuits that, when in operation, receive input and generate output according to the input and corresponding to the one or more operations. When a computer program, engine, or module is said to be configured to perform one or more operations, this means that the computer program includes one or more program instructions, that when executed by one or more computers, causes the one or more computers to perform the one or more operations.

Although the technology herein has been described with reference to particular examples, it is to be understood that these examples are merely illustrative of the principles and applications of the present technology. It is therefore to be understood that numerous modifications may be made and that other arrangements may be devised without departing from the spirit and scope of the present technology as defined by the appended claims.

Unless otherwise stated, the foregoing alternative examples are not mutually exclusive, but may be implemented in various combinations to achieve unique advantages. As these and other variations and combinations of the features discussed above can be utilized without departing from the subject matter defined by the claims, the foregoing description should be taken by way of illustration rather than by way of limitation of the subject matter defined by the claims. In addition, the provision of the examples described herein, as well as clauses phrased as "such as," "including" and the like, should not be interpreted as limiting the subject matter of the claims to the specific examples; rather, the examples are intended to illustrate only one of many possible implementations. Further, the same reference numbers in different drawings can identify the same or similar elements.

## Claims

1. A system for optimizing power and thermal control of a server system, the system comprising:
memory;
one or more processors in communication with the one or more memories, the one or more processors configured to:
receive state data of the server system;
determine that a current job is near completion based on the received state data;
reduce an amount of power supplied to the server system over a predefined time period;
reduce a rate of cooling by closing one or more cooling valves over the predefined time period;
change a latency time of the current job or a next scheduled job; and
maintain a temperature of the server system at predefined level based on the reduced amount of the power, the changed latency time, and the reduced rate of cooling.

2. The system of claim 1, wherein the state data includes job schedules, temperatures of one or more components of the server system, and states of the one or more cooling valves for a server cooling system.

3. The system of claim 1, wherein the one or more processors are configured to:
reduce the amount of power supplied to the server system using a dynamic voltage and frequency scaling, DVFS, technique; and/or
reduce fan speeds of one or more fans equipped in the server system to change the temperature of the server system.

4. The system of one of claims 1 to 3, wherein the one or more processors are configured to represent the reduced amount of the power, the changed latency time, and the reduced rate of cooling using a metric function; and
wherein the one or more processors are optionally configured to optimize the metric function using a machine learning model.

5. The system of one of claim 1 to 4, the system comprising one or more actuators configured to control the one or more cooling valves and change the latency time.

6. The system of one of claims 1 to 5, wherein the one or more processors are configured to change the latency time of the current job or the next scheduled job using a scheduler, wherein the scheduler is configured to delay a time of loading the current job or the next scheduled job.

7. A method for optimizing power and thermal control of a server system, the method comprising:
receiving, by one or more processors, state data of the server system;
determining, by the one or more processors, that a current job is near completion based on the received state data;
reducing, by the one or more processors, an amount of power supplied to the server system over a predefined time period;
reducing, by the one or more processors, a rate of cooling by closing one or more cooling valves over the predefined time period;
changing, by the one or more processors, a latency time of the current job or a next scheduled job; and
maintaining, by the one or more processors, a temperature of the server system at predefined level based on the reduced amount of the power, the changed latency time, and the reduced rate of cooling.

8. The method of claim 7, wherein the state data includes job schedules, temperatures of one or more components of the server system, and states of the one or more cooling valves for a server cooling system.

9. The method of claim 7 or 8, further comprising:
reducing, by the one or more processors, the amount of power supplied to the server system using a dynamic voltage and frequency scaling, DVFS, technique; and/or
reducing, by the one or more processors, fan speeds of one or more fans equipped in the server system to change the temperature of the server system.

10. The method of one of claims 7 to 9,
wherein the reduced amount of the power, the changed latency time, and the reduced rate of cooling are represented using a metric function; and
wherein the method optionally further comprises optimizing, by the one or more processors, the metric function using a machine learning model.

11. The method of one of claims 7 to 10, further comprising controlling, by one or more actuators, the one or more cooling valves and changing the latency time.

12. The method of one of claims 7 to 11, further comprising changing the latency time of the current job or the next scheduled job using a scheduler, wherein the scheduler is configured to delay a time of loading the current job or the next scheduled job.

13. A non-transitory machine-readable medium comprising machine-readable instructions encoded thereon for performing a method of optimizing power and thermal control of a server system, the method comprising:
receiving state data of the server system;
determining that a current job is near completion based on the received state data;
reducing an amount of power supplied to the server system over a predefined time period;
reducing a rate of cooling by closing one or more cooling valves over the predefined time period;
changing a latency time of the current job or a next scheduled job; and
maintaining a temperature of the server system at predefined level based on the reduced amount of the power, the changed latency time, and the reduced rate of cooling.

14. The non-transitory machine-readable medium of claim 13, wherein the state data includes job schedules, temperatures of one or more components of the server system, and states of the one or more cooling valves for a server cooling system.

15. The non-transitory machine-readable medium of claim 13 or 14, wherein the method further comprises one or more of:
reducing the amount of power supplied to the server system using a dynamic voltage and frequency scaling, DVFS, technique; and
reducing fan speeds of one or more fans equipped in the server system to change the temperature of the server system.
